Europäisches Patentamt

European Patent Office

Office européen des brevets

(11) Publication number: **0 270 276**
**A1**

## EUROPEAN PATENT APPLICATION

(21) Application number: 87310080.4

(51) Int. Cl.4: **G01R 1/067** , G01R 19/145

(22) Date of filing: **16.11.87**

(30) Priority: **14.11.86 US 931224**
**10.11.87 US 117100**

(43) Date of publication of application:
**08.06.88 Bulletin 88/23**

(84) Designated Contracting States:
**DE ES FR GB IT NL**

(71) Applicant: **ADVANCED SCIENTIFIC CORPORATION**
**3110 Hancock Street**
**San Diego California 92110(US)**

(72) Inventor: **Wood, John P.**
**115 Vallarta Court**
**Solana Beach California 92075(US)**

(74) Representative: **Wilson, Nicholas Martin et al**
**WITHERS & ROGERS 4 Dyer's Buildings**
**Holborn**
**London EC1N 2JT(GB)**

(54) Circuit testing device.

(57) A circuit testing device (10) of the insulation piercing type comprises a hollow outer sleeve (14) having a hook member (16) at one end for hooking over a wire to be tested and a jaw member (22) slidable in the sleeve member between a retracted position and an advanced position in which it opposes the hook member (16) to grip a wire between the hook (16) and jaw member (22). A conductive probe (26) having a pointed end is slidable axially in the jaw member (22) between a retracted position and an advanced position in which it contacts any wire held between the hook (16) and jaw member (22), piercing any insulation covering the wire. The segment of the hook member (16) which opposes the probe (26) has no holes in order to provide solid support backing to the wire to be tested, to prevent damage to the wire and to insure good contact by the probe (26). A manually operable actuator successively moves the jaw member (22) and probe (26) into their advanced positions, and a is provided to maintain any such advanced positions. A signaling device such as a lamp bulb (44) connected to the probe (26) indicates the existence of any electrical current passing through the wire contacted by the probe (26).

EP 0 270 276 A1

## CIRCUIT TESTING DEVICE

## BACKGROUND OF THE INVENTION

This invention relates generally to a circuit testing device having a conductive probe for piercing any insulation covering a wire to be tested. Such devices are generally manually operated.

Known electrical circuit testing devices of this general type are normally hand held and have a needle for contacting a wire. The wire to be tested is held with one hand as the needle point is pushed through the insulation to make contact. A suitable signaling device, such as a light bulb, buzzer or visual read-out device, is connected in circuit with the probe to provide a signal if the circuit is completed by contact with the wire to be tested. Normally a conductive wire extends from the testing device and may be clamped or clipped to another point of the circuit to provide a ground or complete circuit to indicate whether a break or short has occurred and to allow the probe to locate any such break or short for repair purposes. Some devices of this type include a hook for locating a wire as the probe is advanced into contact with it.

Problems with such testing devices are that users often need two hands for proper operation and the devices do not always align the wire properly for contact with the probe. If the pointed end of the probe does not pierce the center of the insulation covered wire, it may miss the conductor altogether, resulting in an inaccurate indication of an open circuit, thus damaging the insulation and possibly exposing the conductor to corrosion from the environment.

One example of an insulation piercing test device of the hook type is shown in U.S. Patent No. 3,363,171 of Sietmann et al. This device comprises an outer case of the gun-type in which a conductive probe is slidably mounted. The case has a hook at one end for hooking around a wire, and a trigger at the opposite end for urging the probe into contact with any wire located by the hook. If the wire is not correctly centered in the hook, or if it slips to one side during operation, the probe may miss the wire altogether. A similar arrangement is shown in U.S. Patent No. 3,996,511 of Baer and U.S. Patent No. 3,768,005 of Louks.

Another testing device is shown in French Published Application no. 2,444,940 to Martinet et al. This device, however, is necessarily constructed with a hole in the jaw opposite the probe, in order to allow the probe to extend outwardly from the device. The presence of the hole prevents the device from being able to test small diameter wires, for the absence of a firm backing for the wire resulting from the presence of the hole will lead to having a small wire either severed by the probe or forced into the hole where good electrical contact is difficult or impossible. Further, the device locks in only one advanced position.

## SUMMARY OF THE INVENTION

It is an object of the present invention to provide an improved circuit testing device.

According to the present invention a circuit testing device is provided which comprises a hollow outer sleeve having first and second jaw members at one end which are movable relative to one another to grip a wire between their opposed jaws. A probe is movable relative to one of the jaw members to contact any size wire held between the jaws. The jaw member where opposed to the probe has a solid surface without holes so that very small diameter wire can be positively supported while being tested. The probe and jaws are lockable at a variety of positions.

In the preferred embodiment of the invention, one of the jaws comprises a hook projecting from one end of the sleeve for engaging over a wire to be tested. The other jaw member is slidable in the sleeve between a retracted position within the sleeve and an advanced position in which it opposes the hook to clamp any wire engaged by the hook between the opposed jaws. The slidable jaw member preferably comprises two separate V-shaped jaws and the hook has openings aligned with the jaws. The jaws slide into the openings to allow smaller size wires to be gripped. The jaw portion between the openings and opposite the probe is solid to provide back up support for the wire. This acts to ensure that the wire is accurately centered and held in its centered position while being adequately supported. A conductive probe is slidable axially in the jaw member between a retracted position and an advanced position in which it contacts any size wire held between the opposed hook and jaw member, the probe having a pointed end for piercing any insulation covering the wire. A suitable manual actuator acts to urge the jaw member and probe successively into their advanced positions, so that the jaw member first grips and centers the wire, and the probe is then advanced to contact the wire accurately without any movement of the wire out of center position. This device thus is capable of accurately testing all size wires.

In an alternative arrangement the hook may be slidably mounted on the sleeve and movable between a first position spaced from the end of the sleeve and a second position in which it engages the opposing jaw member to clamp a wire, subsequently pushing back the opposing jaw until the probe pierces any insulation covering the wire to contact it.

Any suitable signaling device may be connected in circuit with the probe for indicating the presence or absence of electrical current passing through the probe. The signaling device may be connected to a suitable releasable electrical connection extending from the test device for connection to a chosen circuit point to test for an open or short circuit between that point and the point on a wire contacted by the probe. For unpowered circuit lines, a battery connection may be provided.

The hook and opposing jaw member preferably have opposed V-shaped jaws for gripping and centering a line to be tested.

The opposing jaw member preferably has at best one flattened side and moves in a channel of corresponding shapes so that the jaw and hook are always properly aligned.

The actuator in a preferred embodiment of the invention comprises a slidable plunger projecting from the opposite end of the sleeve to the hook. The plunger is pushed into the sleeve to urge the jaw member and probe into their advanced positions. The plunger is preferably releasably lockable in the sleeve to hold the advanced jaw member and probe in the advanced position at any desired point, to leave the operator's hand free while the circuit is tested. In one embodiment of the invention locking portions of the sleeve bore and the plunger are of corresponding eccentric cross section, so that rotation or twisting of the plunger in the bore will cause the eccentric portions to move out of alignment and lock against one another to restrict sliding movement of the plunger in the bore to lock the probe in the contacted position. In another embodiment the plunger's movement is controlled and locked at any desired point of travel by a screw mounted in the housing and bearing against the plunger.

Preferably, a finger grip is provided on the sleeve to allow the operator to hold the finger grip with the fingers of one hand while forcing the plunger inwardly with the thumb or palm of the same hand. This allows easy one-handed operation of the device while leaving the other hand free. It is common in locations, such as under the dashboard of an automobile, that two hands cannot be easily placed at the point needing to be tested. In the preferred arrangement the signaling device comprises a bulb or similar device mounted in the sleeve and connected at one end to the conductive probe, with electrical wiring connecting the other end of the bulb to a suitable releasable clamp or clip for connecting to another circuit point.

In the preferred embodiment of the invention a first resilient device urges the jaw member towards its retracted position, while a second, stronger resilient device urges the probe towards its retracted position. These devices suitably comprise springs. Thus the actuator or plunger will first overcome the weaker spring force to urge the jaw member out to its advanced position, and subsequently overcomes the stronger spring force to advance the probe. This ensures that a wire will be gripped and centered before the pointed end of the probe pierces its insulation.

Thus the circuit testing device of this invention is relatively easy to operate and helps to align a wire accurately for contact with the probe. Thus consistency of the device is greatly improved.

## BRIEF DESCRIPTION OF THE DRAWINGS

The present invention will be better understood from the following detailed description of a preferred embodiment of the invention, taken in conjunction with the accompanying drawings, in which like reference numerals refer to like parts, and in which:

Figure 1 is a perspective view of a circuit testing device according to a preferred embodiment of the present invention with a wire held by the device shown partially cut away to reveal the probe piercing the insulation covering the wire.

Figure 2 is partial longitudinal cross-sectional view of the device of Figure 1, showing the wire clamp and probe in their retracted positions.

Figure 3 is an exploded view similar to Figure 2 showing the wire gripping end of the testing device, with the wire clamp and probe in their advanced positions gripping and contacting a wire held by the device.

Figure 4 is a section on the lines 4 - 4 of Figure 2.

Figure 5 is an end view of the outer sleeve of testing device with the plunger, probe and clamp member removed, taken from the upper end as viewed in Figure 2.

Figure 6 is a view of the hooked end of the device similar to Figure 3 showing the clamp gripping a smaller diameter wire.

Figure 7 is a side elevation view, partially in section, of another embodiment of the device.

Figure 8 is a cross-sectional view taken on line 8-8 of Figure 7.

Figure 9 is a cross-sectional view taken on line 9-9 in Figure 7.

Figure 10 is an oblique view of the movable jaw member.

## DESCRIPTION OF THE PREFERRED EMBODIMENT

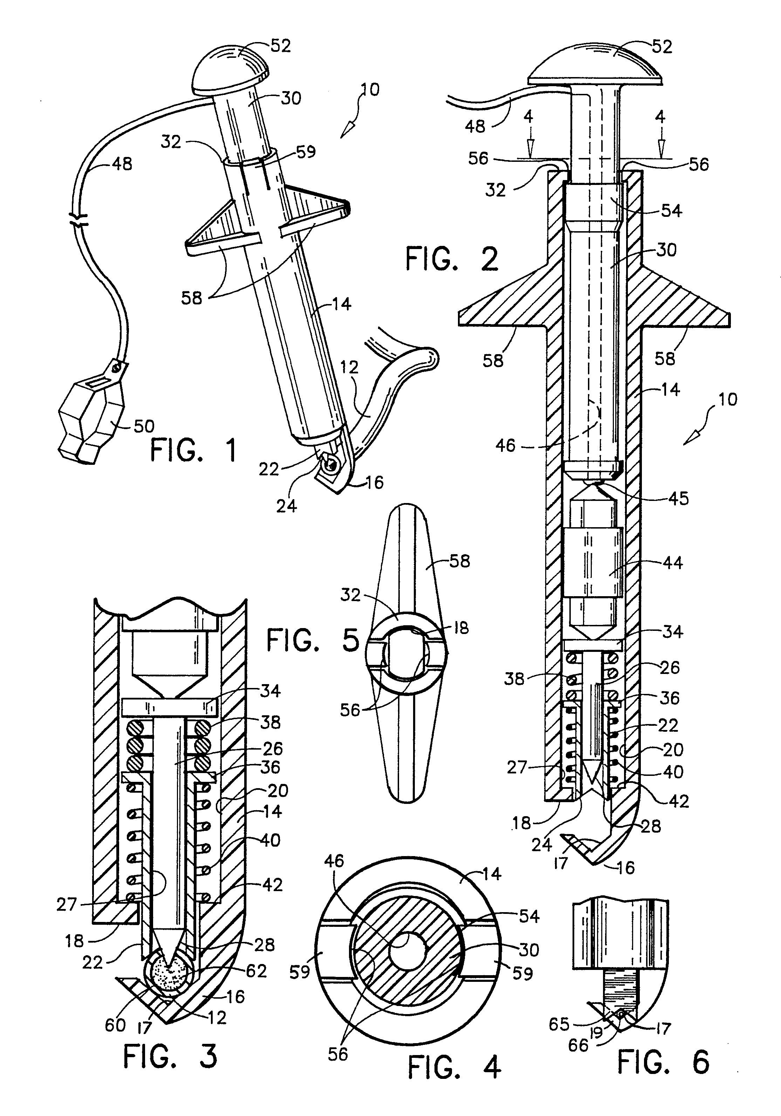

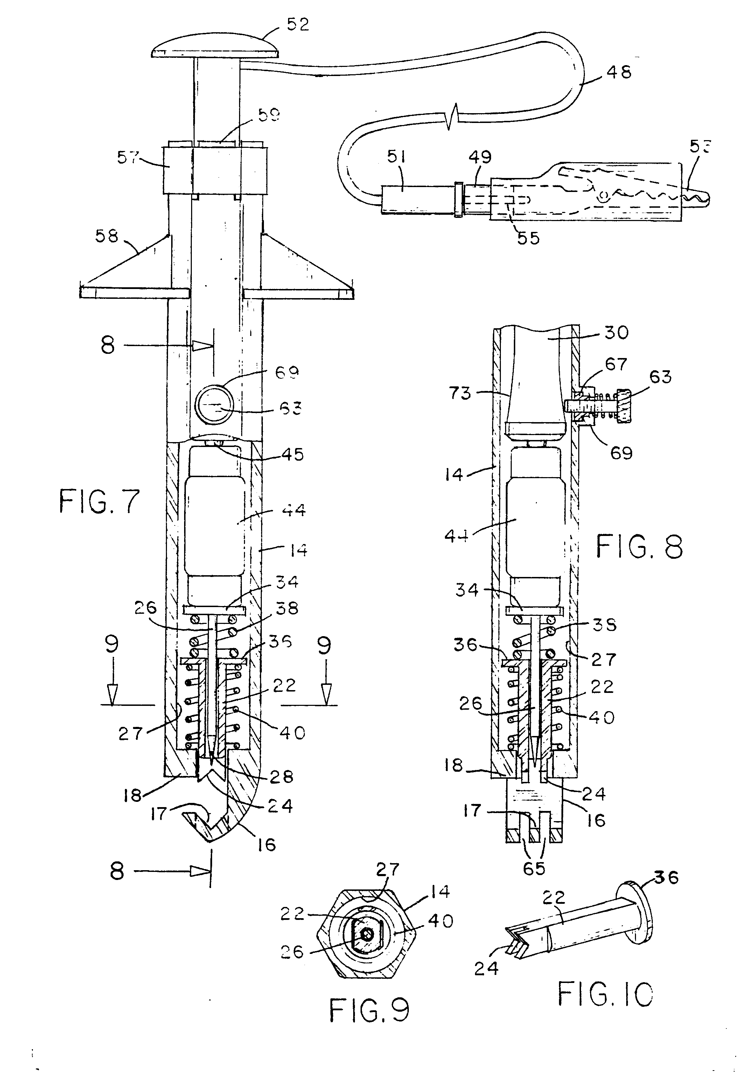

Figures 1 and 2 of the accompanying drawings show a circuit testing device 10 according to a preferred embodiment of the invention for testing a wire or line 12 for opens or shorts. The device 10 basically comprises a hollow outer casing or sleeve 14 of non-conductive material with a hook 16 projecting from one end 18 of the sleeve bore 20 for hooking around a wire 12 as indicated in Figures 1 and 3. Clamp or jaw member 22 is slidably mounted at the end 18 of the bore as shown in Figures 2 and 3 and has a V-shaped jaw portion 24 facing the hook 16, which is also of generally V-shaped section. The jaw member is slidable between the retracted position shown in Figure 2 and the advanced position shown in Figure 3 in which it opposes hook 16 to grip a wire firmly between the jaw 24 and hook 16. As seen in Figure 5, the open end 18 of the bore is of non-circular cross section, and the clamp member 22 has a corresponding outline as shown in Figure 10 to ensure that the jaw portion 24 remains accurately centered relative to the sleeve bore. The cross-section may be square, but preferably is rounded on two opposite sides as shown in Figures 5 and 10, to ensure that upon assembly the jaw 24 is correctly aligned with hook 16. The clamp member and hook comprise opposing first and second jaw members which are relatively movable between the released position of Figure 2 and 7 and the advanced, wire gripping position of Figure 3.

A conductive probe 26 having a pointed end 28 extends axially into a central, open ended bore 27 in clamp or jaw member 22 and is movable between the retracted position of

Figure 2 in which the pointed end is within the bore and the advanced position of Figure 3 where it projects out of the bore to contact any wire gripped between the opposing V-shaped jaws of hook and clamp member as shown. An axially slidable probe actuating plunger 30 projects into the opposite end 32 of the sleeve bore to urge the clamp member and probe successively into their advanced positions, as explained in more detail below.

The center portion 17 of hook 16 is solid and has no hole or other opening where it opposes the end 28 of probe 26, as shown in Figures 3, 5, and 8. This permits very small diameter wires (such as 66) to be secured and accurately tested because they are firmly and adequately supported. In contrast, prior art devices which have holes for their probes to pass through cannot test such small wires, for the probe forces such wires into the opposing hole where they have so support. The wires thus become severed or, at the least, the probe does not properly contact the wire and the test is inaccurate or impossible to conduct.

Both the probe and the clamp member have enlarged diameter flange portions 34 and 36, respectively, at their inner ends. A first spring 38 acts between the flange portions 34 and 36 to urge the probe towards its retracted position, and a second, weaker spring 40 acts between the clamp member flange portion 36 and a rim 42 at the end of the bore to urge the clamp member towards its retracted position. A suitable signaling device, such as a light bulb 44 as shown in Figures 2, 7 and 8 or any other suitable signaling device such as a buzzer, for example, is electrically connected to the probe 26. As shown in Figure 2, the light bulb 44 contacts probe flange 34 at one end and contacts a conductive button 45 at the inner end of non-conductive plunger 30 at the opposite end. The button 45 is attached to a conductive ground wire 48. The casing 14 is suitably of translucent plastic or other non-conductive material, at least in the area of the bulb, so that the bulb is visible to the user. The plunger, which is also of non conductive material such as plastic, has an axial bore 46 through which the ground wire 48 extends to connect the bulb 44 to a conventional external clip 50 for connection to a line or mainframe grounding point in a circuit to be tested in the conventional manner.

As an alternative to clip 50 one may use a banana jack 51 which plugs into the final socket end 49 of an alligator clip 53. This allows the wire 48 to contact a variety of types of grounds, either by connection with clip 53, or, after removing the banana jack 51 from the socket, by the probe 55 of the jack 51. The probe 55 may also be plugged into a voltmeter to give a quantitative measure of the voltage.

As best seen in Figure 2, the plunger 30 has an enlarged boss or button 52 at its outer end which projects from the casing and is of generally cylindrical cross-section with dimensions chosen to allow it to slide freely in casing bore 20. The plunger has a first enlarged diameter portion 54 which has a snap fit engagement over diametrically opposed projections 56 (see Figures 4 and 5) at the end 32 of the casing bore, the projections acting as a detent to retain the plunger in the bore unless it is positively pulled out by the user, for example when the bulb needs to be replaced. The projections 56 on split detents 59 may be retained against accidental passage of plunger 30 by restraining collar 57 (Figure 7) which has a sliding fit on the outside of casing 14. Collar 57 may be moved up or down to release detents 59.

The enlarged diameter portion 54 preferably may have an outer diameter of eccentric cross section, and the inner diameter of bore 20 is of corresponding eccentric cross section, as seen in Figure 4. Thus the plunger can be locked against sliding movement by rotating it so that the opposing eccentric surfaces of the bore and plunger portion 54 move out of alignment and into frictional contact with one another to restrict any further relative movement. The plunger can therefore be easily locked in position in the bore by simply twisting it into locking engagement with the bore eccentric. This can be done with one hand. In one specific example, the smallest diameter of the eccentric section of the plunger and bore was of the order of 0.474 and 0.477 inches, respectively while the largest diameter of the eccentric was of the order of 0.481 and 0.484 inches, respectively.

In another preferred embodiment, shown in Figures 7 and 8, a restraining spring-loaded screw 63 is mounted in threaded hole 67 in boss 69 on the side of casing 14. In inner end of screw 63 can bear against plunger 30, thus restraining it at any desired point in its movement path. By tapering plunger 30 as at 73 any tendency of the plunger to back out and loosen the probe contact is avoided

The casing or barrel 14 has diametrically opposed finger grips or projections 58 for gripping by the operator while urging the plunger into the bore. Thus the operator can grip the projections with the fingers of one hand while pushing the boss 52 of plunger 30 inwardly with the thumb or palm of the same hand, allowing the device to be operated easily with one hand.

Operation of the device to test a wire will now be described in detail. The operator will first connect wire clip 50 to one side of an element or circuit to be tested, in the conventional manner. The line 12 is then grasped by hook 16, and the operator urges the plunger inwardly with one hand by gripping the finger grips 58 while pushing on the boss. As the plunger moves inwardly, it will first compress the weaker spring 40, urging the clamping member 22 outwardly into its advanced position opposing the hook to clamp the line 12 between the hook and V-shaped jaw 24 of the clamp member, as shown in Figure 3. The opposing V-shaped jaws, which are aligned with the sleeve center axis, will act to center the wire relative to the plunger 30.

As shown in Figures 6 and 10 the V-shaped jaw 24 is preferably in two parts, one on each side of the bore, effectively forming two separate jaws. The hook 16 has corresponding slots 65 aligned with the separate jaws so that the device can clamp smaller diameter wires 66 as shown in Figure 6 with the jaws 24 protruding partially through the slots 60 in the hook. The slots 65 also function to keep the mold pin aligned when the casing is being manufactured by injection molding.

As soon as the stronger force of spring 38 is overcome by the plunger, this spring will also be compressed and the plunger 30 will start to move outwardly. This may be before the clamp member is fully extended, or after the member 22 reaches its fully extended position. As the plunger moves outwardly its pointed end will pierce any insulation 60 covering the wire 62, and will contact the wire which is centered in the jaws, as shown in Figure 3. At this point the plunger may be locked in the casing bore by twisting it into locking engagement with the eccentric inner diameter of the bore or by using screw 63, so that both hands of the operator are left free while the circuit is under test. Thus the actuator or plunger will advance the clamp member and probe successively into their operative positions so that the wire is first positively gripped and centered, and the probe is then advanced to contact it.

When the plunger contacts the conductive wire 62 of line 12 as shown in Figure 3, any current in the circuit under test will cause the bulb 44 to light. Thus lighting of the bulb 44 indicates to the operator that the line under test is conducting current, while if the bulb does not light a possible circuit break is indicated.

In an alternative embodiment of the invention (not shown), instead of having the hook 16 fixed while the jaw or clamp member 22 and probe 26 move successively out of bore 27, the hook 16 may itself be slidable on the end of the sleeve member 14. In this case the jaw or clamp member will project out of the open end of the sleeve while the probe, which may be fixed in position, projects into an axial bore in the clamp member as in the illustrated embodiment. An actuator will be provided for drawing the hook back towards the open end of the sleeve bore, so that any wire located in the hook will first be clamped in position between the opposed jaws on the hook and clamp member. Further retraction of the hook will also force the spring loaded clamp member back into the sleeve, exposing the pointed end of the probe so that it can pierce any covering insulation and contact the clamped wire. Both the jaw or clamp member and the hook will be spring loaded towards the released position. Thus, instead of providing an actuator arranged to urge a first jaw outwardly, the actuator in this embodiment will urge the second jaw or hook inwardly against the first jaw.

The circuit testing devices described above can be used for testing uncovered circuit lines or lines covered by insulation, and are easy and convenient to use. The accuracy is improved since the line will be positively centered relative to the probe and will be clamped in its centered position while the probe is advanced into contact with the wire. Thus the possibility of the pointed end of the probe missing the wire due to misalignment and giving a

false open circuit indication is substantially reduced or eliminated. Contact with the wire can therefore be more consistently accurate than with some previous insulation piercing probes, where the probe could miss the wire altogether if the line was not correctly centered or if the line moved while the probe was being advanced.

Although a preferred embodiment of the invention has been described above by way of example, it will be understood by those skilled in the field that modifications may be made to the disclosed embodiment without departing from the scope of the invention, which is defined by the appended claims.

**Claims**

1. A circuit testing device, comprising:
a hollow outer sleeve;
first and second opposing jaw members mounted at one end of the sleeve, one of the jaw members being movable relative to the other jaw member between a retracted position spaced from the other jaw member and an advanced position in which it opposes the other jaw member to clamp any size wire located between the jaw members in a centered position;
a conductive probe mounted at said one end of the sleeve and extending axially into the first jaw member, the probe and said first jaw member being movable relative to one another between a retracted position in which the probe is within the jaw member and an advanced position in which it projects out of the end of the jaw member to contact a wire held between the opposing jaw members, the probe having a pointed end for piercing any insulation covering the wire;
that portion of the jaw member opposite said probe being without openings and providing a solid support for said wire during said piercing of said wire by said probe;
manually operable actuator means for urging said one jaw member and said probe successively into their advanced positions; signaling means connected to the probe for indicating the existence of an electric current passing through the probe; and

2. The device as claimed in claim 1, wherein the second jaw member comprises a hook projecting from said one end of said outer sleeve for hooking over a wire to be tested.

3. The device as claimed in claim 2, wherein the first jaw member is slidable axially in said one end of said sleeve between a retracted position and an advanced position in which it opposes said hook to clamp a wire between opposed surfaces of said hook and first jaw member, and said probe is slidable axially in the first jaw member.

4. The device as claimed in claim 3, wherein the first jaw member comprises two spaced jaws, one on each side of the probe, and the hook has two slots aligned with jaws for slidably receiving the jaws for gripping wires of varying diameter.

5. The device as claimed in claim 3, including first resilient means for urging the first jaw member towards its retracted position, and second resilient means for urging the probe towards its retracted position, the second resilient means being stronger than the first so that the actuator means first overcomes the first resilient means to urge the first jaw member towards its advanced position and then overcomes the second resilient means to urge the probe towards its advanced position.

6. The device as claimed in claim 5, wherein the sleeve has an open ended bore, the hook projecting from one end of the bore and the actuator means projecting from the opposite end of the bore, the first resilient means comprising a first spring acting between the first jaw member and said one end of the bore, and the second resilient means comprising a second, stronger spring acting between the first jaw member and the probe.

7. The device as claimed in claim 1, wherein the sleeve has an open ended bore, the second jaw member comprising a V-shaped hook member projecting from a first end of the bore and having its opening facing inwardly, the first jaw member being axially slidable in the first end of the bore and having a corresponding V-shaped jaw at its outer end facing the hook member.

8. The device as claimed in claim 7, wherein the first end of the bore and the outer surface of the first jaw member are of corresponding square cross section.

9. The device as claimed in claim 7, wherein the first jaw member has an axial through bore, and the probe comprises a probe member slidable relative to the first jaw member and having a pointed outer end extending into one, inner end of the jaw member bore in the retracted position and projecting out through the opposite end of the bore in the advanced position.

10. The device as claimed in claim 9, wherein the first jaw member and probe member each have enlarged diameter inner end portions, and a first spring is located between the inner end of the first jaw member and said first end of the sleeve bore to urge the first jaw member inwardly, and a second, stronger spring acts between the inner end portions of the first jaw member and probe member to urge the probe member inwardly.

11. The device as claimed in claim 3, wherein the actuator means comprises a plunger slidable in the sleeve at the opposite end to the hook for urging the first jaw member and probe out of said one end of the sleeve into the advanced position.

12. The device as in claim 1, further comprising locking means to maintain said movable jaw member and said probe at any such advanced position.

13. The device as claimed in claim 12, wherein locking means comprises co-operating twist lock means on the sleeve and plunger for locking the plunger in said advanced position in the sleeve.

14. The device as claimed in claim 13, wherein the twist lock means comprises corresponding eccentric cross-section inner and outer diameters on at least part of the sleeve and plunger, respectively.

15. The device as claimed in claim 12, wherein said locking means comprises a screw threaded through an opening in the said of said sleeve and aligned to move transversely of said sleeve, said screw when moved inwardly contacting the outer surface of said actuator means and releasably restraining said actuator against coaxial movement within said sleeve.

16. The device as claimed in claim 14 wherein said screw is seated in a boss extending outwardly from said side of said sleeve.

FIG. 1

FIG. 2

FIG. 3

FIG. 4

FIG. 5

FIG. 6

FIG. 7

FIG. 8

FIG. 9

FIG. 10

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| D,Y | FR-A-2 444 940 (R. MARTINET et al.)<br>* Page 4, lines 14-39; page 5, line 15 - page 6, line 3; figures 1-6 * | 1-9,11 | G 01 R 1/067<br>G 01 R 19/145 |
| D,Y | US-A-3 363 171 (V.H. SIETMANN et al.)<br>* Column 3, lines 25-29; figure 4 * | 1-9,11 | |
| A | FR-A-2 422 959 (R. MARTINET et al.)<br>* Page 8, lines 4-23; figure 7 * | 7,8 | |
| A | US-A-2 457 506 (S.H. SORENSEN)<br>* Column 2, lines 5-24; figure 3 * | 12 | |
| A | US-A-3 201 746 (C.S. ASKEW)<br>* Column 2, lines 35-47; figure 1 * | 15 | |

TECHNICAL FIELDS
SEARCHED (Int. Cl.4)

G 01 R

The present search report has been drawn up for all claims

| Place of search | Date of completion of the search | Examiner |
|---|---|---|
| THE HAGUE | 15-02-1988 | PENZKOFER,B. |